# EUROPÄISCHE PATENTSCHRIFT

(11) **EP 2 624 454 B1**
(45) Veröffentlichungstag und Bekanntmachung des Hinweises auf die Patenterteilung: **14.05.2014**
(21) Anmeldenummer: 13153844.9
(22) Anmeldetag: 04.02.2013
(51) Int. Cl.: H03K 17/96

(54) **Kapazitive Sensorvorrichtung mit einem Federkontakt**
Capacitive sensor with spring contact
Sensor capacitif avec contact à ressort

(30) Priorität: 03.02.2012 DE 102012201600
(43) Veröffentlichungstag der Anmeldung: 07.08.2013
(73) Patentinhaber: Irlbacher Blickpunkt Glas GmbH, 92539 Schönsee (DE)
(72) Erfinder: Irlbacher, Günther, 92539 Schönsee (DE); Winter, Peter, 92559 Winklarn (DE)
(74) Vertreter: Hinkelmann, Klaus

(56) Entgegenhaltungen:
- EP-A2- 2 169 315
- WO-A1-2004/107062
- DE-A1-102010 030 315
- DE-U1-202005 002 157
- DE-U1-202005 007 480
- JP-A- 2005 044 247
- "Forschung Akuell, LCD-TV Bildschirme im Grossformat", December 2007 (2007-12), Bayer AG, Leverkussen
- Jan Oliver Löfken: "Kunststoff statt Glas für LCD-Anzeigen", Bild der Wissenschaft, 11 June 2001 (2001-06-11), Retrieved from the Internet: URL:http://www.wissenschaft.de/technik-kom munikation/computer/-/journal_content/56/1 2054/1204175

## Beschreibung

Die Erfindung betrifft eine kapazitive Sensorvorrichtung mit einem Federkontakt sowie ein bevorzugtes Verfahren zu deren Herstellung. Die Erfindung betrifft insbesondere eine kapazitive Sensorvorrichtung mit einer Frontplatte aus Glas und einer Sensorplatte mit mindestens einer elektrisch leitfähigen Schicht, welche bei Annäherung eines Objektes an die kapazitive Sensorvorrichtung und/oder Berührung der kapazitiven Sensorvorrichtung durch das Objekt ein elektrisches Signal erzeugen kann.

Berührungsempfindliche Sensorvorrichtungen, auch Touchscreens genannt, werden immer häufiger in vielfältigen Bereichen eingesetzt, wie zum Beispiel als Bedienpanel zur Steuerung von Haushaltsgeräten, Maschinen und Anlagen, bei Elektrokleingeräten wie Computern, Telefonen und ähnlichem. Im Gegensatz zu mechanischen Druckschaltern sind berührungsempfindliche Sensorvorrichtungen weniger abnutzungsanfällig, leicht zu reinigen und werden von Benutzern als ästhetisch ansprechend empfunden. Insbesondere wurden in den letzten Jahren zunehmend Sensorvorrichtungen der so genannten "Projected Capacitive Touch" (PCT)-Technologie eingesetzt, bei der die Touch-Erkennung durch eine Schutzscheibe vor einem Display ermöglicht wird. Solche PCT-Touchscreens können wetterbeständig ausgebildet sein, wodurch sie insbesondere auch im Außenbereich eingesetzt werden können.

Bei Sensorvorrichtungen befinden sich üblicherweise die Sensorelektroden auf einem Sensorsubstrat, beispielsweise aus Glas oder Kunststoff. Außerdem beinhalten insbesondere PCT-Sensorvorrichtungen häufig voneinander getrennte Sensorschichten einerseits für die Detektion in Richtung einer X-Achse und andererseits für die Detektion in Richtung einer Y-Achse, wodurch die Berührungsposition nicht nur auf kleinen vordefinierten Sensorfeldern sondern über den gesamten Bereich bestimmbar ist. Bei solchen herkömmlichen Sensorvorrichtungen werden die Sensorelemente oder Sensorschichten über Flexleitungen, z.B. FPC-Kabel und Flachbandkabel, mit der Auswerteelektronik verbunden.

So offenbart die GB 2 458 117 A ein kapazitives Touch-Panel mit einer Oberflächenschicht und einem Basissubstrat aus stark lichtdurchlässigem Material wie beispielsweise Glas. Zwischen diesen befinden sich eine die X-Achse abtastende Schicht und eine die Y-Achse abtastende Schicht, beispielsweise jeweils ein Indium-Zinnoxid (ITO)-Film, die voneinander durch einen transparenten isolierenden Film, z.B. einen hochtransparenten Polyesterfilm, getrennt sind. X-Achse und Y-Achse abtastende Schicht haben jeweils eine Vielzahl von X-bzw. Y-Linien, die mit einem FPC-Kabel verbunden sind.

Nachteilig ist bei einer solchen Sensorvorrichtung jedoch, dass zur Gewährleistung einer zuverlässigen Verbindung zwischen Flexleitung und Sensorelektroden die Flexleitung im Allgemeinen elektrisch leitfähig mit der Sensorelektrode am Sensorsubstrat verklebt werden muss. Dies erfordert einen separaten Arbeitsgang. Außerdem sind die Flexleitungen vergleichsweise teuer und der gesamte Aufbau der Sensorvorrichtung kann durch den Einsatz von Flexleitungen unerwünscht dick werden. Zudem sind Sensoren aus organischen Trägermaterialien nicht UV-beständig.

Die DE 201 19 700 U1 beschreibt eine Sensorvorrichtung zur Erzeugung eines Schaltsignals mit einem kapazitiven Sensorelement, das als Schicht fest auf die Rückseite einer Blende aufgebracht ist, und mittels einer elektrisch leitfähigen Verbindung mit der Steuerung, die selbst nicht auf der Blende aufgebracht ist, verbunden ist. Die Blende ist vorzugsweise aus einem durchsichtigen Material wie Glas oder Glaskeramik. Die elektrische Verbindung des Sensorelements mit der Steuerung erfolgt beispielsweise über ein längliches und stiftartiges Kontaktteil wie eine metallische Schraubenfeder oder kann aus leitfähigem, elastischem Kunststoff sein. Jedoch ist der Einsatzbereich dieses Aufbaus der Sensorvorrichtung beschränkt, da beispielsweise keine PCT-Sensorvorrichtungen mit voneinander getrennten X- und Y-Achsen-Sensorschichten verwirklicht werden können.

Die DE 10 2007 020 592 A1 offenbart einen berührungsempfindlichen Sensor mit einer Steuerkreisplatine und einem Sensorsubstrat, beispielsweise aus biegsamem Kunststoff, mit darauf abgeschiedenen durchscheinenden Sensorelektroden, wobei die elektrische Verbindung zwischen Sensorsubstrat und Steuerkreisplatine durch einen nachgiebigen elektrischen Anschlussstecker, wie beispielsweise eine Metallblattfeder, hergestellt wird. Steuerkreisplatine und Sensorsubstrat können mit einem geeigneten Haftmaterial an einer Glasabdeckplatte befestigt werden. Auch hier wird durch einen solchen Aufbau der Sensorvorrichtung nur eine beschränkte Einsatzbreite ermöglicht, da beispielsweise Sensorsubstrate aus Kunststoff nur begrenzt UV-beständig sind und somit für den Einsatz im Außenbereich nur bedingt einsetzbar.

Die japanische Offenlegungsschrift JP 2005 - 44247 beschreibt eine Anzeigevorrichtung, welche eine Sensorvorrichtung und ein LCD-Panel beinhaltet. Dabei soll eine Verbindung der Sensorvorrichtung mit einer flexiblen Leiterplatte stattfinden. Über den Ort der Anbringung der flexiblen Leiterplatte und damit den Ort der Anbringung der Auswerteelektronik gibt es keine Angaben. Im Wesentlichen soll die Anzahl der Leiterplatten verringert werden, weil sich die Steuerung von Sensorvorrichtung und LCD-Panel auf einer Leiterplatte befinden.

Die DE 20 2005 002 157 U1 beschreibt eine kapazitive Sensorvorrichtung umfassend ein Berührungsfeld, eine Haltevorrichtung, welche unter der Unterseite des Berührungsfeldes angeordnet ist, und ein aus einer Feder gemachtes Sensorelement, welches sich von der Haltevorrichtung zur Unterseite des Berührungsfeldes erstreckt, wobei die Feder einen erweiterten Teil aufweist, welcher bei Kompression abgeflacht wird, um einen erweiterten Kontaktbereich auf der Unterseite des Berührungsfeldes auszubilden. Es wird auch erwähnt, dass im Bereich häuslicher Anwendungen die Verwendung kapazitiver Berührungssteuerungen, welche durch Glas- oder Plastikfelder bedient werden, nun sehr gebräuchlich ist.

Die WO 2004/107062 A1 beschreibt einen kapazitiven Berührungsschalter, insbesondere eine Sensorvorrichtung zur Erzeugung eines Schaltsignals bei Annäherung und/oder Berührung eines Sensorelementes durch Annäherung eines Fingers oder dergleichen. Das Sensorelement ist ein kapazitives Sensorelement, das eine Fläche definiert und eine durchsichtige Bedruckung oder Beschichtung mit leitfähigem Material aufweist. Sonstige für die vorliegende Erfindung relevante Information sind dieser Druckschrift nicht zu entnehmen.

Aufgabe der Erfindung war es vor diesem Hintergrund, eine kapazitive Sensorvorrichtung bereitzustellen, deren Aufbau einen großen Einsatzbereich ermöglicht und die einfach und kostengünstig herzustellen ist. Aufgabe der Erfindung war außerdem die Bereitstellung eines Verfahrens zur Herstellung einer solchen Sensorvorrichtung.

Die Lösung dieser Aufgabe wird nach dieser Erfindung erreicht durch eine kapazitive Sensorvorrichtung sowie ein Verfahren zu ihrer Herstellung mit den Merkmalen der entsprechenden unabhängigen Patentansprüche. Bevorzugte Ausführungsformen der erfindungsgemäßen Sensorvorrichtung sind in entsprechenden abhängigen Patentansprüchen aufgeführt. Bevorzugten Ausführungsformen der erfindungsgemäßen Sensorvorrichtung entsprechen bevorzugte Ausführungsformen des erfindungsgemäßen Verfahrens und umgekehrt, selbst wenn dies hierin nicht explizit festgestellt wird.

Gegenstand der Erfindung ist somit eine kapazitive Sensorvorrichtung mit einer Frontplatte aus Glas (im Folgenden auch als "Glas-Frontplatte" bezeichnet) und einer Sensorplatte mit mindestens einer elektrisch leitfähigen Schicht, welche bei Annäherung eines Objektes an die kapazitive Sensorvorrichtung und/oder Berührung der kapazitiven Sensorvorrichtung durch das Objekt ein elektrisches Signal erzeugen kann, wobei
(a) die Sensorplatte aus Glas besteht und einer ersten Oberfläche der Frontplatte zugewandt ist;
(b) eine Auswerteelektronik für die elektrischen Signale direkt auf der unbeschichteten oder beschichteten ersten Oberfläche der Frontplatte angeordnet ist; und
(c) die mindestens eine elektrisch leitfähige Schicht mit der Auswerteelektronik über mindestens einen Federkontakt verbunden ist, wobei die Sensorplatte dünner als die Frontplatte ist, die Frontplatte eine Dicke von 1 bis 10 mm und die Sensorplatte eine Dicke im Bereich von 0,3 bis 3 mm hat, und zwischen Frontplatte und Sensorplatte mindestens ein Abstandshalter angeordnet ist.

Hierin bedeutet eine kapazitive Sensorvorrichtung im Allgemeinen eine Sensorvorrichtung, bei der durch Annäherung an diese und/oder deren Berührung, beispielsweise mit einem Finger, einem Stift oder ähnlichem, ein durch Änderungen der elektrischen Kapazität hervorgerufenes elektrisches Signal erzeugt wird. Das Objekt ist somit insbesondere eine Person, insbesondere ein Finger der Person, oder ein Stift. Im Allgemeinen ist hierzu die Frontplatte dem Benutzer zugewandt, so dass die Annäherung und/oder Berührung an der Frontplatte erfolgt.

Erfindungsgemäß ist die Frontplatte aus Glas. Dies hat mehrere Vorteile. Der Aufbau der Sensorvorrichtung kann von einem Benutzer aus gesehen hinter der Glas-Frontplatte liegen. Glas bietet gute Witterungsbeständigkeit und gewährleistet somit den Schutz der Sensorvorrichtung. Außerdem ist es leicht zu reinigen, was den Einsatz auch in solchen Bereichen ermöglicht, in denen eine häufige Reinigung erforderlich ist, insbesondere auch in Bereichen, in denen es auf eine gute Hygiene ankommt. Weiterhin lassen sich auf Glas transparente und nicht-transparente Bereiche erzeugen, wobei transparente Bereiche insbesondere für eine Hinterlegung der Sensorvorrichtung mit einem Display vorteilhaft sind. Dabei können beispielsweise auf der Frontplatte Leuchtmittel wie Dioden angebracht sein.

Bevorzugt weist die Frontplatte mindestens einen transparenten Bereich auf, insbesondere mehrere transparente und nicht-transparente Bereiche. Besonders bevorzugt ist die Sensorplatte im Wesentlichen vom Benutzer aus gesehen hinter dem transparente Bereiche aufweisenden Teil der Frontplatte angeordnet und die Auswerteelektronik hinter einem nicht-transparenten Bereich. Ganz besonders bevorzugt ist vom Benutzer aus gesehen hinter der Sensorvorrichtung in transparenten Bereichen der Frontplatte ein Display angeordnet.

Die Auswerteelektronik ist auf einer ersten Oberfläche der Frontplatte angeordnet. Im Allgemeinen handelt es sich bei dieser ersten Oberfläche der Frontplatte um die dem Benutzer abgewandte Oberfläche der Frontplatte. Somit befindet sich die Auswerteelektronik in der Regel auf der dem Benutzer abgewandten Seite der Frontplatte.

Der Begriff "Auswerteelektronik" umfasst hierin insbesondere elektronische Bauteile, Leiterbahnstrukturen und Lötverbindungen, und ggf. weitere Komponenten.

Vorzugsweise weist die erfindungsgemäße kapazitive Sensorvorrichtung keine Leiterplatte auf.

Die Sensorplatte besteht ebenfalls aus Glas (hierin auch als "Glas-Sensorplatte" bezeichnet). Dies hat einerseits den Vorteil, dass durch die UV-Beständigkeit von Glas die erfindungsgemäße Sensorvorrichtung auch im Außenbereich gut einsetzbar ist. Außerdem ist eine Glas-Sensorplatte sehr gut beschichtbar, beispielsweise mit der mindestens einen elektrisch leitfähigen Schicht.

Das für Frontplatte und Sensorplatte ausgewählte Glas kann identisch sein. Falls getrennte Glassorten für Frontplatte und Sensorplatte gewählt werden, wird für die Frontplatte vorzugsweise Floatglas und für die Sensorplatte vorzugsweise gezogenes oder gefloatetes Glas verwendet.

Die Sensor-Glasplatte ist dünner als die Frontplatte aus Glas (hierin auch als "Front-Glasplatte" bezeichnet). Außerdem ist die Sensor-Glasplatte vorteilhaft entspiegelt und weist bevorzugt eine ESD-Schutzschicht zur Vorbeugung gegen elektrostatische Entladung (ESD, electrostatic discharge) auf.

Die Front-Glasplatte kann bei ausreichender Dicke die Schutzfunktion gut erfüllen und zudem den Aufbau der Sensorvorrichtung sowie ggf. weitere Komponenten tragen. Die Front-Glasplatte hat eine Dicke von 1 bis 10 mm, vorzugsweise von 2 bis 5 mm, besonders bevorzugt von 2 bis 3,5 mm.

Die Sensorplatte hingegen ist vorteilhaft dünn ausgebildet. Die Sensor-Glasplatte weist eine Dicke im Bereich von 0,3 bis 3 mm, vorzugsweise im Bereich von 0,5 bis 2,5 mm, besonders bevorzugt im Bereich von 0,6 bis 2 mm auf. Dadurch kann der Aufbau der erfindungsgemäßen Sensorvorrichtung dünn gehalten werden. Ein möglicher Parallaxenfehler, beispielsweise bei Vorhandensein eines hinter der Sensorvorrichtung angeordneten Displays, bleibt dann klein. Außerdem ist es bei Ausführungsformen, bei denen die Sensor-Glasplatte auf beiden Oberflächen elektrisch leitfähige Schichten aufweist, vorteilhaft, dass der Abstand zwischen diesen elektrischen Schichten gering ist. Ganz besonders bevorzugt weist die Sensor-Glasplatte eine Dicke im Bereich von 0,6 bis 0,8 mm auf.

Die Sensorplatte ist erfindungsgemäß mit mindestens einer elektrisch leitfähigen Schicht versehen. Diese elektrisch leitfähigen Schichten dienen, im Allgemeinen nach einer entsprechenden Strukturierung, als Sensorelektroden für eine Berührung der Sensorplatte. Die Sensorelektroden können vielfältige Formen von einfachen geometrischen Formen, wie Kreise, Rechtecke usw., bis hin zu komplizierten unregelmäßigen Formen aufweisen. Bevorzugt werden Linien aus elektrisch leitfähigem Material in X- und Y-Richtung. Dabei können die Linien in X-Richtung von den Linien in Y-Richtung getrennt in mehreren elektrisch leitfähigen Schichten vorliegen oder gemeinsam in einer elektrisch leitfähigen Schicht, beispielsweise in einer gitterartigen Anordnung. Beispielsweise kann eine elektrisch leitfähige Schicht auf einer ersten Oberfläche der Sensorplatte vorliegen und/oder eine elektrisch leitfähige Schicht auf einer zweiten Oberfläche der Sensorplatte.

In einer bevorzugten Ausführungsform der kapazitiven Sensorvorrichtung ist eine erste elektrisch leitfähige Schicht auf einer der Frontplatte zugewandten ersten Oberfläche der Sensorplatte angeordnet. Dies hat den Vorteil, dass der Abstand zwischen der Oberfläche der Frontplatte, auf der die Berührung erfolgt, und den Sensorelektroden, die durch die mindestens eine elektrisch leitfähige Schicht bereit gestellt werden, so gering wie möglich gehalten wird, wodurch eine sehr genaue Abbildung der Berührung erzielt wird. Falls mehr als eine elektrisch leitfähige Schicht auf der der Frontplatte zugewandten ersten Oberfläche der Sensorplatte angeordnet werden, können diese ggf. voneinander getrennt angeordnet werden, indem beispielsweise geeignete Filme, z.B. aus Kunststoff, zwischen den elektrisch leitfähigen Schichten angebracht werden. Jedoch ist es bevorzugt, dass genau eine elektrisch leitfähige Schicht auf der der Frontplatte zugewandten ersten Oberfläche der Sensorplatte angeordnet ist.

Vorzugsweise ist mindestens eine zweite elektrisch leitfähige Schicht auf einer der Frontplatte abgewandten zweiten Oberfläche der Sensorplatte angeordnet. In diesem Fall sind die mindestens eine elektrisch leitfähige Schicht auf der der Frontplatte zugewandten ersten Oberfläche und die mindestens eine weitere elektrisch leitfähige Schicht auf der der Frontplatte abgewandten zweiten Oberfläche durch die Sensorplatte voneinander getrennt. Bevorzugt umfasst eine elektrisch leitfähige Schicht auf der der Frontplatte zugewandten ersten Oberfläche Linien aus leitfähigem Material in X-Achsen-Richtung und eine weitere elektrisch leitfähige Schicht auf der der Frontplatte abgewandten zweiten Oberfläche Linien aus leitfähigem Material in Y-Achsen-Richtung oder umgekehrt. Hierbei ist es besonders bevorzugt, die Dicke der Sensorplatte so gering wie möglich zu halten. Vorzugsweise sollte die Dicke der Sensorplatte dabei 2 mm, besonders bevorzugt 0,8 mm, nicht überschreiten.

Die mindestens eine elektrisch leitfähige Schicht auf der Sensorplatte weist elektrisch leitfähiges, vorzugsweise transparentes Material auf, beispielsweise Indium-Zinnoxid (ITO). Im Allgemeinen wird eine solche elektrisch leitfähige Schicht durch Sputtern auf der Sensorplatte erzeugt. Andere Herstellungsmethoden sind möglich. Beispielsweise kann die Sensorplatte mit einem Film aus einem elektrisch leitfähigen Material mit einem geeigneten Druckverfahren, z.B. Siebdruck, auf die Sensorplatte aufgebracht und anschließend eingebrannt werden. In diesem Zusammenhang hat die erfindungsgemäße Sensorplatte aus Glas wiederum den Vorteil, dass bei einer Glas-Sensorplatte eine Beschichtung bei Temperaturen bis zu 300 - 700°C einbrennbar ist. Zudem besteht die Möglichkeit, kommerziell erhältliche vorgefertigte Glasplatten mit einer ITO-Beschichtung direkt als Sensorplatten mit mindestens einer elektrisch leitfähigen Schicht einzusetzen.

Erfindungsgemäß ist die Sensorplatte der ersten Oberfläche der Frontplatte zugewandt angeordnet. Dies bedeutet, dass die Sensorplatte im Allgemeinen vom Benutzer aus gesehen hinter der Frontplatte angeordnet ist. Außerdem ist gemäß der Erfindung auf der ersten Oberfläche der Frontplatte die Auswerteelektronik angeordnet, so dass die Sensorplatte der Seite der Frontplatte mit der Auswertelektronik zugewandt ist, um eine vorteilhafte Verbindung von Sensorplatte und Auswerteelektronik zu ermöglichen.

Die mindestens eine elektrisch leitfähige Schicht der Sensorplatte ist erfindungsgemäß mit der Auswerteelektronik über mindestens eine elektrische Verbindung verbunden. Dadurch werden die durch Annäherung und/oder Berührung erzeugten elektrischen Signale zur weiteren Verarbeitung an die Auswerteelektronik vermittelt.

Erfindungsgemäß ist die mindestens eine elektrische Verbindung ein Federkontakt. Dadurch kann eine zuverlässige elektrische Verbindung auf relativ einfache und kostengünstige Weise hergestellt werden. Der Federkontakt ist in der Regel mit einer Vorspannung ausgebildet, da durch eine solche Vorspannung ein zuverlässiger Kontakt hergestellt wird. Im Allgemeinen enthält der Federkontakt Metall oder besteht aus diesem. Der Federkontakt kann auch aus einem nicht-leitenden Material bestehen, welches dann vorteilhaft nachträglich teilweise beschichtet wird, um eine hybride Funktion bereitzustellen.

Als Federkontakt kann beispielsweise eine herkömmliche Metallblattfeder verwendet werden, aber auch individuell angepasste Ausführungsformen des Federkontakts werden vorteilhaft verwendet. So ist beispielsweise ein gegabelter Federkontakt möglich, um an zwei oder mehr Stellen mit der elektrisch leitfähigen Schicht der Sensorplatte und/oder mit der Auswerteelektronik der Frontplatte den Kontakt herzustellen. Andererseits kann der Kontakt des Federkontakts mit mindestens einer Stelle der elektrisch leitfähigen Schicht der Sensorplatte und/oder der Auswerteelektronik der Frontplatte vorteilhaft durch Kontaktkalotten des Federkontakts hergestellt werden. Solche Kontaktkalotten ermöglichen einen punktgenauen Kontakt und sind somit bevorzugt. Weiterhin kann vorteilhaft an den Stellen der elektrisch leitfähigen Schicht der Sensorplatte und/oder der Auswerteelektronik der Frontplatte, an denen ein Kontakt mit dem Federkontakt vorgesehen ist, eine Carbonbeschichtung angebracht werden, beispielsweise durch Aufdrucken. Hierdurch wird der elektrische Kontakt nochmals verbessert.

In der Regel kontaktiert der Federkontakt die elektrisch leitfähige Schicht der Sensorplatte im Randbereich der Sensorplatte. Insbesondere ist es bevorzugt, dass der Federkontakt die Auswerteelektronik in einem nicht-transparenten Bereich der Frontplatte kontaktiert und dass auch die Kontaktierung des Federkontakts mit der elektrisch leitfähigen Schicht der Sensorplatte vom Benutzer aus gesehen durch einen nicht-transparenten Bereich der Frontplatte verdeckt wird. Auf diese Weise ist durch die Anordnung des nicht-transparenten Bereichs der Frontplatte im Zusammenhang mit der Anordnung des Federkontakts und der Sensorplatte der Federkontakt für den Benutzer nicht sichtbar.

In einer weiteren bevorzugten Ausführungsform der erfindungsgemäßen kapazitiven Sensorvorrichtung wird der Federkontakt über eine Clip-Verbindung an der Sensorplatte befestigt. Die Ausbildung der Clip-Verbindung ist erfindungsgemäß nicht eingeschränkt. Vorteilhaft ist die Clip-Verbindung derart ausgebildet, dass der Federkontakt einen Verbindungsclip beinhaltet. Somit kann der Federkontakt mit dem Verbindungsclip auf die Sensorplatte aufgeclipt werden, beispielsweise auf den Rand der Sensorplatte. Da der Federkontakt eine elektrische Verbindung von der elektrisch leitfähigen Schicht leitfähigen Schicht der Sensorplatte mit der Auswerteelektronik bildet und da der Verbindungsclip in der Regel den Kontakt zur elektrisch leitfähigen Schicht vermittelt, enthält der Verbindungsclip in der Regel elektrisch leitfähiges Material oder besteht aus diesem. Besonders bevorzugt ist ein Federkontakt aus Metall, der direkt an die Sensorplatte angeclipt werden kann. Vorteilhaft ist der Federkontakt mit Verbindungsclip derart ausgebildet, dass er auf den Rand der Sensorplatte aufgeclipt werden kann und dann sowohl die mindestens eine leitfähige Schicht auf der der Frontplatte zugewandten Oberfläche der Sensorplatte wie auch ggf. die mindestens eine weitere elektrisch leitfähige Schicht auf der der Frontplatte abgewandten zweiten Oberfläche der Sensorplatte bei Bedarf kontaktieren kann. Der Verbindungsclip kann außerdem vorteilhaft noch durch einen geeigneten Kleber, beispielsweise einen UV-härtenden Kleber, an der Sensorplatte fixiert werden.

Bie der erfindungsgemäßen kapazitiven Sensorvorrichtung ist zwischen der Frontplatte und der Sensorplatte mindestens ein Abstandshalter angeordnet. Somit ist in die Sensorplatte von der Frontplatte durch einen über den mindestens einen Abstandshalter definierten Abstand a getrennt.

Durch den Abstandshalter wird gewährleistet, dass der Federkontakt nicht zu stark zusammengedrückt wird und dadurch seine Federwirkung verliert. Insbesondere weist der Federkontakt im Zusammenwirken mit der Möglichkeit, mit dem mindestens einen Abstandshalter einen definierten Abstand a zwischen Frontplatte und Sensorplatte bereitzustellen, besondere Vorteile auf. Wenn die Frontplatte nicht direkt mit der Sensorplatte verklebt wird, können durch den Federkontakt Abstandtoleranzen, die beispielsweise dadurch entstehen, dass eine Glasplatte nie vollständig planar ist, ausgeglichen werden. Weiterhin wird eine durch den Kleber bedingte Materialermüdung vermieden. Insbesondere kann es bei einer vollständigen Verklebung von Front- und Sensorplatte durch unterschiedliche thermische Ausdehnungskoeffizienten zu Abrissen kommen. Das ist beispielsweise bei Außenanwendungen von großer Bedeutung. Insbesondere aber auch, wenn hinter der Sensorplatte ein Display angeordnet wird, da insbesondere in diesen Fällen Temperaturunterschiede zwischen Frontplatte und Sensorplatte auftreten. Dies wird noch verstärkt durch eine mögliche Wärmeentwicklung von Leuchtmitteln wie beispielsweise Leuchtdioden.

Außerdem kann durch den mindestens einen Abstandshalter ein umlaufend gleicher Abstand zwischen Frontplatte und Sensorplatte erreicht werden, indem genau definiert werden kann, wie groß der Abstand a zwischen Frontplatte und Sensorplatte sein soll.

Die Ausbildung des Abstandshalters ist nicht eingeschränkt. Jedoch werden bestückbare Bauelemente, wie SMD-Bauteile, beispielsweise Null-Ohm-Widerstände oder auch Kondensatoren oder Kupferblöcke, bevorzugt eingesetzt. Diese Bauelemente können in dem Bestückungsvorgang der Auswerteelektronik mit an der Frontplatte und/oder an einer zur Auswerteelektronik gehörenden Leiterplatte angebracht werden, so dass kein separater Arbeitsgang notwendig ist, um die Abstandshalter anzubringen. Andererseits sind auch andere Ausbildungen der Abstandshalter möglich, wie beispielsweise Kunststoffblöcke. Die Verbindung der Abstandshalter mit der Sensorplatte ist vorteilhaft elastisch, um die oben genannten Vorteile in größtmöglichem Umfang zu gewähren. Beispielsweise wird die Verbindung durch ein geeignetes Haftmaterial hergestellt, bevorzugt durch einen Epoxidharzkleber, der die Elastizität gewährleistet.

Die Anordnung der Abstandshalter erfolgt bevorzugt derart, dass die Abstandshalter für den Benutzer nicht sichtbar sind, beispielsweise in einem nicht-transparenten Bereich der Frontplatte und im Randbereich der Sensorplatte.

Insbesondere ist es bevorzugt, dass bei dieser Ausführungsform der Sensorvorrichtung der Abstand a zwischen der Frontplatte und Sensorplatte ≤ 1 mm, vorzugsweise ≤ 0,5 mm, besonders bevorzugt ≤ 0,4 mm beträgt. Wenn der Abstand größer ist, kann dies unter Umständen zu Verlusten bei der Genauigkeit der Registrierung des Touchsignals durch die Sensorelektroden, zu Parallaxenfehlern bei hinter der Sensorvorrichtung angeordnetem Display und/oder zu einem unerwünscht dicken Gesamtaufbau der Sensorvorrichtung führen. Besonders bevorzugt liegt der Abstand a im Bereich von 0,2 bis 0,35 mm.

Weiterhin kann es vorteilhaft sein, wenn der mindestens eine Abstandshalter elektrisch leitfähig ist und eine elektrische Verbindung zwischen der mindestens einen elektrisch leitfähigen Schicht und der Auswerteelektronik bereitstellt. Auf diese Weise kann eine weitere elektrische Verbindung neben dem Federkontakt bereitgestellt werden, beispielsweise bei der Verwendung von SMD-Bauteilen wie Null-Ohm-Widerständen und Kupferblöcken.

Außerdem können vorteilhaft der mindestens eine Abstandshalter und der Federkontakt in einem Bauteil integriert sein. So kann beispielsweise ein Bauelement aus Metall derart ausgebildet sein, dass es einerseits sowohl die Federfunktion ausführen kann, andererseits aber auch die Funktion des Abstandshalters. Ein solches Bauteil kann einerseits ein Federelement beinhalten, andererseits aber auch einen starr ausgebildeten Fortsatz, der als Abstandshalter dient. Da ein solches Bauelement aus Metall zudem elektrisch leitfähig ist, können durch die geeignete Ausbildung von Kontaktkalotten und ggf. unter Ausnutzung des als Abstandshalter dienenden Fortsatzes vorteilhaft vielfältige Möglichkeiten einer elektrischen Verbindung bereit gestellt werden.

Weiterhin ist es bei der kapazitiven Sensorvorrichtung bevorzugt, dass sich in dem durch die Abstandshalter zwischen Frontplatte und Sensorplatte definierten Zwischenraum ein Füllmaterial befindet. Ein solches Füllmaterial kann beispielsweise ein geeigneter Kleber sein. Bevorzugt wird hier ein Epoxidharz eingesetzt. Das Füllmaterial hat einerseits den Vorteil, dass es den durch den Abstand a gebildeten Zwischenraum zwischen Frontplatte und Sensorplatte abdichtet, so dass kein Schmutz eindringen kann. Andererseits ist es insbesondere bei großen Touchscreens mit dünnem Sensorglas möglich, dass durch die Berührung hervorgerufene Erschütterungen der Glasplatte zu einer ungenauen Abbildung der Berührung führen können, was durch ein entsprechendes Füllmaterial vermieden wird.

Bei der kapazitiven Sensorvorrichtung der Erfindung, die mit mindestens einem Abstandshalter versehen ist, ist die Auswerteelektronik direkt auf einer unbeschichteten oder beschichteten ersten Oberfläche der Frontplatte angebracht. Hierin bedeutet "direkt auf einer unbeschichteten oder beschichteten ersten Oberfläche der Frontplatte angebracht", dass die Auswerteelektronik insbesondere nicht auf einer Leiterplatte angebracht ist. Somit dient die Frontplatte aus Glas als Trägermaterial für die Elektronik. Auf diese Weise entfällt die Leiterplatte und eine vorteilhaft geringe Aufbauhöhe der Sensorvorrichtung wird ermöglicht. Zudem entfällt der Arbeitsschritt der Befestigung der Leiterplatte an der Frontplatte.

In einer bevorzugten Ausführungsform der kapazitiven Sensorvorrichtung ist die erste Oberfläche der Frontplatte mindestens teilweise mit einer oder mehreren Keramikfarben und/oder Leiterbahnstrukturen beschichtet. Bevorzugt sind die Leiterbahnstrukturen aus leitfähigem Silber.

Es ist dabei bevorzugt, dass zwischen der ersten Oberfläche der Frontplatte und den Leiterbahnstrukturen mindestens eine weitere Schicht angebracht ist. Die Art der Schicht ist nicht eingeschränkt, jedoch ist mindestens eine Dekorschicht, beispielsweise eine Lackschicht, besonders vorteilhaft. Beispielsweise kann durch das Anbringen einer Dekorschicht auf einer durchgängig transparenten Frontplatte vorteilhaft ein nichttransparenter Bereich der Frontplatte bereitgestellt werden. Die Beschichtung kann auf verschiedene Weise angebracht werden, beispielsweise durch Aufbringen eines Beschichtungsfilms oder durch geeignete Druckverfahren. Besonders bevorzugt ist das Anbringen der Beschichtung durch Siebdruck. Dabei werden zur Beschichtung besonders bevorzugt keramische und UV-stabile Siebdrucklacke verwendet.

Bevorzugt ist eine kapazitive Sensorvorrichtung, bei der die beschichtete erste Oberfläche der Frontplatte erhältlich ist durch gleichzeitiges Einbrennen der Keramikfarben und/oder Leiterbahnstrukturen, beispielsweise bei einer Temperatur im Bereich von 600 bis 700°C.

Weiterhin ist es erfindungsgemäß bevorzugt, dass die Frontplatte der Sensorvorrichtung aus gehärtetem Einscheiben-Sicherheitsglas besteht. Dadurch wird eine kratzfeste Oberfläche und hohe mechanische Festigkeit erzielt. Außerdem dient dies auch dem Schutz der Sensorvorrichtung. Somit wird eine Vielzahl von Einsatzmöglichkeiten, die beispielsweise eine robuste Oberfläche der Sensorvorrichtung erfordern, erschlossen. Insbesondere bietet sich hier eine Kombination mit der Ausführungsform, bei der die Leiterbahnstrukturen der Auswerteelektronik auf der unbeschichteten oder beschichteten ersten Oberfläche der Frontplatte angebracht werden, an. Wenn solche Leiterbahnstrukturen und/oder Dekorschichten in die Glas-Frontplatte eingebrannt werden, kann dies durch geeignete Wahl der Brenntemperatur derart erfolgen, dass die Glas-Frontplatte gleichzeitig, also ohne zusätzlichen Arbeitsgang, zum Einscheiben-Sicherheitsglas gehärtet wird.

Gegenstand der Erfindung ist außerdem ein Verfahren zur Herstellung einer kapazitiven Sensorvorrichtung mit einer Frontplatte aus Glas und einer Sensorplatte mit mindestens einer elektrisch leitfähigen Schicht, welche bei Annäherung eines Objektes an die kapazitive Sensorvorrichtung und/oder Berührung der kapazitiven Sensorvorrichtung durch das Objekt ein elektrisches Signal erzeugen kann, wobei
(a) die Sensorplatte aus Glas besteht und einer ersten Oberfläche der Frontplatte zugewandt ist;
(b) eine Auswerteelektronik für die elektrischen Signale direkt auf der unbeschichteten oder beschichteten ersten Oberfläche der Frontplatte angeordnet ist; und
(c) die mindestens eine elektrisch leitfähige Schicht mit der Auswerteelektronik über mindestens einen Federkontakt verbunden ist, wobei die Sensorplatte dünner als die Frontplatte ist, die Frontplatte eine Dicke von 1 bis 10 mm und die Sensorplatte eine Dicke im Bereich von 0,3 bis 3 mm hat, und zwischen Frontplatte und Sensorplatte mindestens ein Abstandshalter angeordnet ist;
wobei das Verfahren die folgenden Schritte umfasst:
(i) Beschichten mindestens eines Teils der ersten Oberfläche der Frontplatte mit mindestens einer Keramikfarbe und/oder Leitstrukturen;
(ii1) Aufbringen der Auswerteelektronik auf der beschichteten ersten Oberfläche der Frontplatte;
(iii) Anbringen von mindestens einem Federkontakt auf der ersten Oberfläche der Frontplatte oder der Sensorplatte; und
(v) Verbinden von Frontplatte und Sensorplatte.

Vorzugsweise wird beim erfindungsgemäßen Verfahren die Frontplatte im Schritt (ii1) oder im Schritt (ii2) mit mindestens einem Abstandshalter bestückt. Die Abstandshalter können sowohl mit der Frontplatte als auch mit der Sensorplatte verbunden sein, beispielsweise durch Löten oder Kleben. Vorzugsweise ist der oder die Abstandshalter nur mit der Frontplatte verbunden.

In einer bevorzugten Ausführungsform geschieht das Verbinden von Frontplatte und Sensorplatte durch Verkleben. Hierbei werden Frontplatte und Sensorplatte vorzugsweise über Klebepunkte oder Klebelinien miteinander verbunden. Das dabei verwendete Klebemittel kann beispielsweise ein Epoxidklebemittel sein. Jedoch sind auch andere Klebe- und Kontakttechniken möglich.

Hierzu wird vorzugsweise in einem Schritt (iv) vor Schritt (v) das Klebemittel geeignet auf die erste Oberfläche der Frontplatte oder der Sensorplatte aufgebracht, vorzugsweise auf die erste Oberfläche der Frontplatte.

In dem, insbesondere durch die Abstandshalter definierten, Zwischenraum zwischen Frontplatte und Sensorplatte kann sich ein Füllmaterial befinden, z.B. eine Kunststoffmasse. Die Kunststoffmasse ist nicht besonders eingeschränkt. Hierbei kann es sich aber beispielsweise ebenfalls um ein Klebemittel handeln.

Wenn eine Befüllung des durch Abstandshalter gebildeten Zwischenraums zwischen Frontplatte und Sensorplatte mit Füllmaterial vorgesehen ist, so kann diese vorzugsweise ebenfalls im Schritt (iv) erfolgen, insbesondere wenn das gleiche Material zur Verklebung und zur Befüllung verwendet wird, wie beispielsweise Epoxidharz.

Das Beschichten mindestens eines Teils der ersten Oberfläche der Frontplatte mit mindestens einer Keramikfarbe und/oder Leitstrukturen wird vorzugsweise durchgeführt, indem mindestens eine Keramikfarbe und/oder Leitpaste auf der ersten Oberfläche der Frontplatte aufgedruckt und in einem Arbeitsgang eingebrannt werden.

Hierzu wird bevorzugt ein Verfahren nach der EP 1 705 163 B1 verwendet. Dies hat nicht nur den Vorteil, dass ein Arbeitsgang eingespart werden kann. Durch die Wahl einer geeigneten Brenntemperatur kann im gleichen Arbeitsgang die Frontplatte ggf. auch zu Einscheiben-Sicherheitsglas gehärtet werden. Außerdem kann dadurch eine verbesserte Verbindung der einzelnen Schichten erreicht werden, so dass diese stärker aneinander haften.

Das Aufbringen der Auswerteelektronik auf der beschichteten ersten Oberfläche der Frontplatte kann durch Bestückung der ersten Oberfläche der Frontplatte, die hierzu im Allgemeinen bereits Leitstrukturen aufweist, mit entsprechenden Elektronikbauteilen erfolgen. Diese Möglichkeit erfolgt, ähnlich der Bestückung einer Leiterplatte, beispielsweise mittels SMD-Löten und hat den Vorteil, dass der zusätzliche Arbeitsschritt der separaten Befestigung der Leiterplatte an der Frontplatte entfällt.

Dabei wird vorteilhaft in diesem Arbeitsgang der Bestückung, beispielsweise des SMD-Lötens, auch der oder die Federkontakte mit an der Auswerteelektronik angebracht, d.h. angelötet. Somit muss kein zusätzlicher Arbeitsgang für die Anbringung des Federkontakts an die Frontplatte durchgeführt werden.

Falls jedoch der Federkontakt derart ausgebildet ist, dass er zuerst an der Sensorplatte befestigt werden sollte, da dies aufgrund der speziellen Ausbildung später nicht mehr möglich ist, entfällt in diesem Schritt die Bestückung der Frontplatte mit dem Federkontakt. Die Frontplatte wird in diesem Fall mit der Auswerteelektronik bestückt und der Federkontakt wird an der Sensorplatte angebracht. Dies kann insbesondere bei bestimmten Arten einer Clip-Verbindung der Fall sein, wenn beispielsweise der Verbindungsclip den Rand der Sensorplatte umgreift. Hierbei kann es allerdings sinnvoll sein, dass der Federkontakt nach Verbinden der Frontplatte und der Sensorplatte, d.h. nach Schritt (iv), noch an der Frontplatte fixiert wird, beispielsweise durch Löten oder einen leitfähigen Kleber.

Im Schritt (v) wird die Sensorplatte mit der Frontplatte verbunden, wobei die Sensorplatte vorteilhaft einfach an den vorbereiteten Klebestellen, insbesondere Klebepunkte und Klebelinien, angedrückt werden kann. Durch die in Schritt (iv) vorbereitete Klebeschicht wird die Sensorplatte an der Frontplatte befestigt, bevorzugt über mindestens einen Abstandshalter. Ein bereits an der Frontplatte vorbereiteter Federkontakt erhält durch das Andrücken der Sensorplatte an die Frontplatte eine Federspannung und kann somit ohne weiteren Arbeitsgang an der Sensorplatte fixiert sein. Wenn zuvor der Federkontakt bereits an der Sensorplatte, aber noch nicht an der Frontplatte, befestigt wurde, kann der Federkontakt nach Anbringen der Sensorplatte noch an der Frontplatte mit entsprechenden Mitteln, wie z.B. über eine Lötverbindung oder eine leitfähige Verklebung, zusätzlich befestigt werden.

Der Federkontakt kann, beispielsweise in einem Schritt (vi) anschließend an Schritt (v) mit der Sensorplatte durch ein geeignetes Klebemittel, bevorzugt durch einen UV-härtbaren Kleber, fest verbunden werden. Dadurch wird eine zusätzliche Fixierung des Federkontakts an der Sensorplatte erreicht. Dies ist insbesondere bei der Verwendung von aufgeclipten Federkontakten vorteilhaft.

Die Erfindung hat zahlreiche Vorteile. Die erfindungsgemäße kapazitive Sensorvorrichtung vereint die Möglichkeit einer breiten Anwendbarkeit mit einer einfachen und kostengünstigen Herstellung. Diese kapazitive Sensorvorrichtung kann in vielen Bereichen eingesetzt werden, beispielsweise für Sensorvorrichtungen mit PCT-Technologie, für Außenanwendungen oder für sonstige Bereiche, in denen robuste Ausführungen gefordert sind. Auf ein teures und in einem zusätzlichen Arbeitsgang anzubringendes Flex-Kabel kann verzichtet werden, da durch den Federkontakt eine zuverlässige elektrische Verbindung bereitgestellt wird. In bevorzugten Ausführungsformen ermöglicht die kapazitive Sensorvorrichtung eine sehr dünne Bauweise. Darüber hinaus ermöglicht die kapazitive Sensorvorrichtung der Erfindung eine gute Wärmeleitung. Diese Eigenschaft ist vorteilhaft insbesondere bei der gemeinsamen Verwendung zusammen mit Leuchtmitteln, beispielsweise Leuchtdioden.

Die Erfindung wird im Folgenden anhand nicht einschränkend gemeinter Ausführungsbeispiele für eine erfindungsgemäße Sensorvorrichtung illustriert.

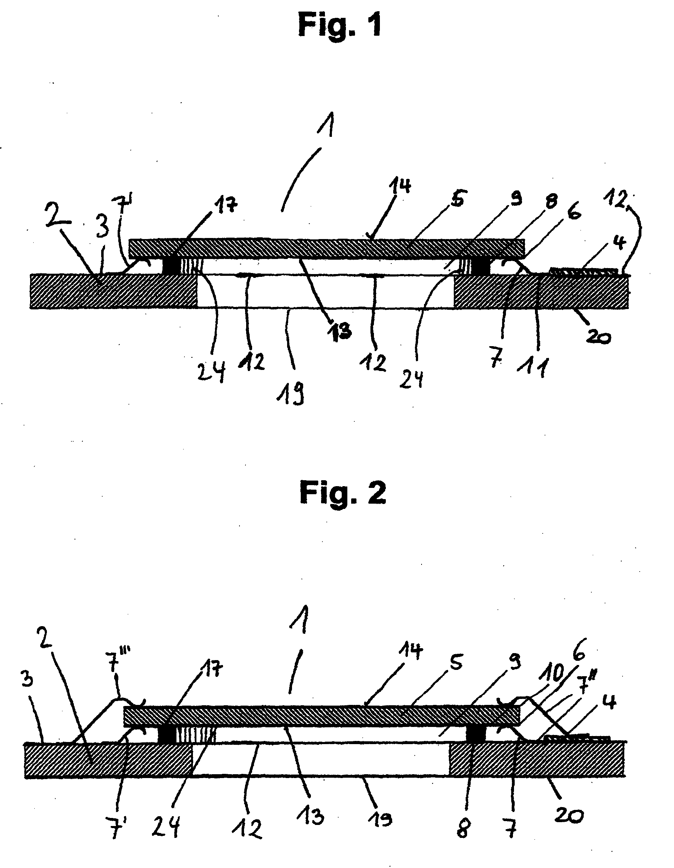

Die Fig. 1 zeigt einen Querschnitt durch eine erfindungsgemäße kapazitive Sensorvorrichtung gemäß einer ersten Ausführungsform der Erfindung, bei der eine elektrisch leitfähige Schicht auf der der Frontplatte zugewandten ersten Oberfläche der Sensorplatte angeordnet ist.

Die Fig. 2 zeigt einen Querschnitt durch eine erfindungsgemäße kapazitive Sensorvorrichtung gemäß einer zweiten Ausführungsform der Erfindung, bei der eine erste elektrisch leitfähige Schicht auf der der Frontplatte zugewandten ersten Oberfläche der Sensorplatte angeordnet ist und eine zweite elektrisch leitfähige Schicht auf der der Frontplatte abgewandten zweiten Oberfläche der Sensorplatte angeordnet ist.

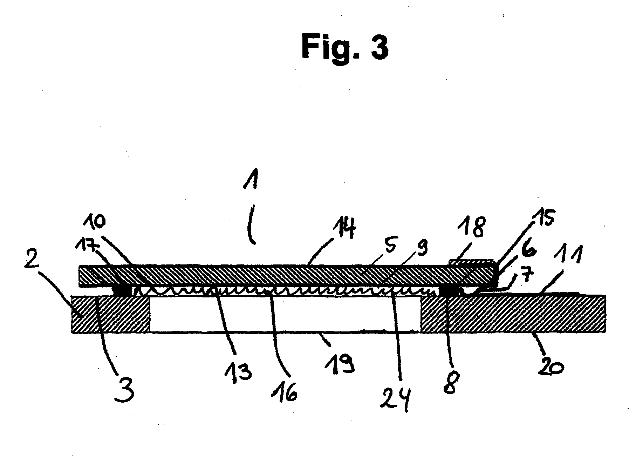

Die Fig. 3 zeigt einen Querschnitt durch eine kapazitive Sensorvorrichtung gemäß einer dritten Ausführungsform der Erfindung, bei welcher ein Federkontakt über eine Clip-Verbindung an der Sensorplatte befestigt ist.

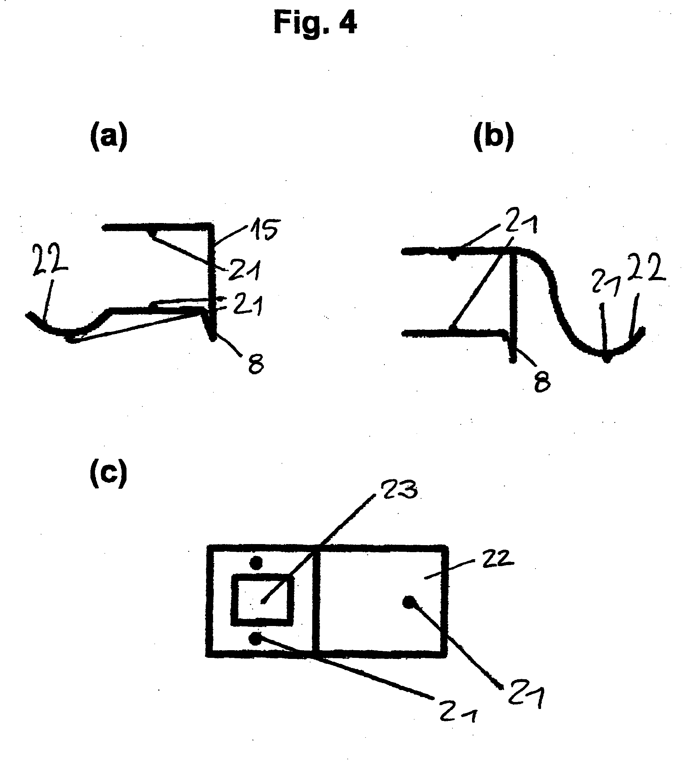

Die Fig. 4a - c zeigen zwei Beispiele für Federkontakte, die bei der erfindungsgemäßen kapazitiven Sensorvorrichtung eingesetzt werden können. Fig. 4a zeigt den Querschnitt einer ersten Ausführungsform eines Federkontakts, Fig. 4b den Querschnitt einer zweiten Ausführungsform eines Federkontakts und Fig. 4c zeigt die Draufsicht auf die zweite Ausführungsform eines Federkontakts.

In der Figur 1 ist ein Querschnitt durch eine nicht einschränkend gemeinte Ausführungsform einer erfindungsgemäßen kapazitiven Sensorvorrichtung 1 gezeigt. Die kapazitive Sensorvorrichtung 1 umfasst eine Frontplatte 2 aus Glas mit einer auf einer ersten Oberfläche 3 der Frontplatte 2 angeordneten Auswerteelektronik 4. Die Frontplatte 2 weist einen im Wesentlichen transparenten Bereich 19 und einen nicht-transparenten Bereich 20 auf.

Weiterhin umfasst die kapazitive Sensorvorrichtung 1 eine Sensorplatte 5, deren erste Oberfläche 13 der ersten Oberfläche 3 der Frontplatte 2 zugewandt angeordnet ist. Die Sensorplatte 5 weist somit eine der Frontplatte zugewandte erste Oberfläche 13 und eine der Frontplatte abgewandte zweite Oberfläche 14 auf. Zwischen der Frontplatte 2 und der Sensorplatte 5 befinden sich Abstandshalter 8 und 17, welche bei der hier gezeigten Ausführungsform mittels eines Epoxidklebers mit der Frontplatte 2 verklebt sind. Durch die Abstandshalter 8 ist ein Zwischenraum 9 zwischen Frontplatte 2 und Sensorplatte 5 gebildet, welcher hier mit einem Epoxidkleber als Füllmaterial 24 im Bereich der Abstandshalter 8 und 17 teilweise gefüllt ist. Die die Sensorelektroden beinhaltende elektrisch leitfähige Schicht 6 ist auf der der Frontplatte 2 zugewandten ersten Oberfläche 13 der Sensorplatte angeordnet.

Die elektrische Verbindung zwischen der Auswerteelektronik 4 der Frontplatte 2 und der elektrisch leitfähigen Schicht 6 der Sensorplatte 5 ist insbesondere ein Federkontakt 7. Gezeigt sind außerdem Leiterbahnstrukturen 11 sowie Keramikfarben 12. Außerdem stellt ein Federkontakt 7' eine weitere elektrisch leitfähige Verbindung zwischen der elektrisch leitfähigen Schicht 6 und der Frontplatte 2 dar.

Zur Durchführung des erfindungsgemäßen Verfahrens wird bei der hier gezeigten, nicht einschränkend gemeinten Ausführungsform in einem ersten Schritt mittels Siebdruck eine Leitpaste sowie mindestens eine Keramikfarbe auf der ersten Oberfläche der Frontplatte 2 aufgebracht. Leitpaste und mindestens eine Keramikfarbe werden dann in einem Arbeitsgang eingebrannt und ergeben eine gut haftende Beschichtung mit Leiterstrukturen und Keramikfarben auf der ersten Oberfläche 3 der Frontplatte 2. Anschließend wird die Frontplatte 2 mit der Auswerteelektronik 4, den Federkontakten 7 und 7' sowie den Abstandshaltern 8 und 17 mittels SMD-Löten bestückt. Dies geschieht in einem Arbeitsgang. In einem weiteren Schritt wird ein Klebemittel 24 in den Zwischenraum 9 eingebracht. Danach wird die Sensorplatte 5 mit der elektrisch leitfähigen Schicht 6 durch einfaches Andrücken an der Frontplatte angebracht. Durch die vorbereitete Klebeschicht haftet die Sensorplatte 5 an der Frontplatte 2. Die an der Frontplatte 2 angelöteten Federkontakte 7 und 7' werden durch das Andrücken der Sensorplatte 5 gespannt und so in ihrer Position fixiert.

Fig. 2 zeigt einen Querschnitt durch eine kapazitive Sensorvorrichtung 1 gemäß einer zweiten Ausführungsform der Erfindung, die sich von der ersten Ausführungsform dadurch unterscheidet, dass die Sensorplatte 5 zwei elektrisch leitfähige Schichten 6 und 10 aufweist, wobei eine erste elektrisch leitfähige Schicht 6 auf der der Frontplatte 2 zugewandten ersten Oberfläche 13 der Sensorplatte 5 angeordnet ist und eine zweite elektrisch leitfähige Schicht 10 auf der der Frontplatte 2 abgewandten zweiten Oberfläche 14 der Sensorplatte 5 angeordnet ist. Beide elektrisch leitfähigen Schichten 6 und 10 sind jeweils durch separate Federkontakte 7 und 7' bzw. 7" und 7'" mit der Auswerteelektronik 4 elektrisch verbunden. Außerdem ist der Zwischenraum 9 zwischen Frontplatte 2 und Sensorplatte 5 durch ein Füllmaterial 10, hier ein Epoxidkleber, der zum Verkleben von Frontplatte und Sensorplatte verwendet werden kann, teilweise gefüllt.

Fig. 3 zeigt einen Querschnitt durch eine kapazitive Sensorvorrichtung 1 gemäß einer dritten Ausführungsform der Erfindung, die sich von der zweiten Ausführungsform insbesondere dadurch unterscheidet, dass der Federkontakt 7 einen Verbindungsclip 15 beinhaltet und somit an dem seitlichen Rand der Sensorplatte 5 aufgeclipt ist. Der Federkontakt 7 ist somit in diesem Ausführungsbeispiel über eine Clip-Verbindung an der Sensorplatte 5 befestigt. Zur zusätzlichen Fixierung des Federkontaktes 7 mit Verbindungsclip 15 an der Sensorplatte 5 dient ein UV-härtender Kleber 18.

Außerdem ist in Fig. 3 nicht die Auswerteelektronik 4 dargestellt, sondern lediglich direkt auf die Frontplatte mittels Siebdruck aufgedruckte und eingebrannte Leiterbahnstrukturen 11, die mit der leitfähigen Schicht 6 der Sensorplatte 5 über den Federkontakt 7 in elektrischer Verbindung stehen. Bei der hier gezeigten Ausführungsform einer kapazitiven Sensorvorrichtung füllt ein Epoxidkleber als Füllmaterial den gesamten Zwischenraum 9, so dass hier eine zusammenhängende Klebeschicht 16 vorliegt. Im Übrigen stimmt die dritte Ausführungsform mit der in Figur 2 gezeigten zweiten Ausführungsform überein.

Zur Durchführung des erfindungsgemäßen Verfahrens wird bei der hier gezeigten nicht einschränkend gemeinten Ausführungsform in einem ersten Schritt die Frontplatte 2 mit der Auswerteelektronik 4 und dem Abstandshalter 8 mittels SMD-Löten bestückt, nachdem die Leiterbahnstrukturen 11 aufgedruckt und eingebrannt worden sind. In diesem Arbeitsschritt der Bestückung können jedoch im Gegensatz zu den in den vorigen Ausführungsbeispielen beschriebenen Verfahren die Federkontakte 7 nicht mit an der Frontplatte 2 bestückt werden. Die Federkontakte 7 werden stattdessen an der Sensorplatte 5 aufgeclipt. In einem weiteren Schritt wird eine Klebeschicht 16 auf die Frontplatte 2 aufgebracht und der Zwischenraum 9 zwischen Frontplatte 2 und Sensorplatte 5 mit Füllmaterial 10 zumindest teilweise gefüllt. Danach wird die Sensorplatte 5 mit der elektrisch leitfähigen Schicht 6 durch einfaches Andrücken angebracht und die Federkontakte 7 an der Frontplatte 2 fixiert. Dann werden die Federkontakte zusätzlich durch UV-härtenden Kleber 18 an der Sensorplatte 5 befestigt.

In der Figur 4 sind zwei Ausführungsformen von Federkontakten, die bei der erfindungsgemäßen Sensorvorrichtung eingesetzt werden können, dargestellt.

Dabei zeigt Fig. 4a den Querschnitt einer ersten Ausführungsform eines Federkontakts 7, der einen Verbindungsclip 15 beinhaltet. Ein solcher Federkontakt 7 kann erfindungsgemäß über eine Clip-Verbindung an der Sensorplatte 5 befestigt werden, indem er auf den Rand der Sensorplatte aufgeclipt wird, wie dies beispielsweise in der dritten Ausführungsform dargestellt ist. Außerdem weist der in Figur 4a dargestellte Federkontakt 7 Kontaktkalotten 21 auf, über die der Federkontakt mit einer elektrisch leitfähigen Schicht 6 auf der der Frontplatte 2 zugewandten ersten Oberfläche 13 der Sensorplatte 5 sowie mit einer weiteren elektrisch leitfähigen Schicht 6 auf der der Frontplatte 2 abgewandten zweiten Oberfläche 14 der Sensorplatte 5 eine elektrisch leitende Verbindung ausbilden kann. Eine weitere Kontaktkalotte 21, die an dem Federteil 22 angeordnet ist, dient der Verbindung mit der Auswerteelektronik 4. Zusätzlich verfügt der in Figur 4a dargestellte Federkontakt 7 über einen Abstandshalter 8, so dass Abstandshalter 8 und Federkontakt 7 hier in einem Bauteil integriert sind.

Figur 4b zeigt den Querschnitt einer zweiten Ausführungsform eines Federkontakts 7, der sich von der in Figur 4a gezeigten Ausführungsform dadurch unterscheidet, dass durch eine versetzte Anordnung des Federteils 22 die Kontaktierung der Auswerteelektronik 4 versetzt, an anderer Stelle, angeordnet ist. Eine Draufsicht dieser Ausführungsform in Figur 4c zeigt, dass im Bereich des Verbindungsclips, der zum Kontakt mit der elektrisch leitfähigen Schicht 6 auf der der Frontplatte 2 abgewandten Oberfläche 14 der Sensorplatte 5 vorgesehen ist, eine Materialaussparung 23 vorliegt, da hier die Befestigung mit UV-härtendem Kleber 18 an der Sensorplatte 5 vorgesehen ist. Durch eine solche Materialaussparung 23 wird eine verbesserte Befestigung ermöglicht.

### Bezugszeichenliste

- 1: Kapazitive Sensorvorrichtung
- 2: Frontplatte aus Glas
- 3: erste Oberfläche der Frontplatte
- 4: Auswerteelektronik
- 5: Sensorplatte aus Glas
- 6: erste elektrisch leitfähige Schicht
- 7,7',7",7'": Federkontakte
- 8,8': Abstandshalter
- 9: Zwischenraum zwischen Frontplatte und Sensorplatte
- 10: zweite elektrisch leitfähige Schicht
- 11: Leiterbahnstrukturen (der Auswerteelektronik)
- 12: Keramikfarben(beschichtung)
- 13: Erste Oberfläche der Sensorplatte, der Frontplatte zugewandt
- 14: Zweite Oberfläche der Sensorplatte, der Frontplatte abgewandt
- 15: Verbindungsclip
- 16: Klebeschicht
- 17: Kontaktstellen
- 18: UV-härtender Kleber
- 19: im Wesentlichen transparenter Bereich der Frontplatte
- 20: nicht- transparenter Bereich der Frontplatte
- 21: Kontaktkalotte
- 22: Federteil
- 23: Materialaussparung
- 24: Füllmaterial; z.B. Kunststoffmasse, Klebemittel

## Patentansprüche

1. Kapazitive Sensorvorrichtung (1) mit einer Frontplatte (2) aus Glas und einer Sensorplatte (5) mit mindestens einer elektrisch leitfähigen Schicht (6,10), welche bei Annäherung eines Objektes an die kapazitive Sensorvorrichtung (1) und/oder Berührung der kapazitiven Sensorvorrichtung (1) durch das Objekt ein elektrisches Signal erzeugen kann,
**dadurch gekennzeichnet, dass**
(a) die Sensorplatte (5) aus Glas besteht und einer ersten Oberfläche (3) der Frontplatte (2) zugewandt ist;
(b) eine Auswerteelektronik (4) für die elektrischen Signale direkt auf der unbeschichteten oder beschichteten ersten Oberfläche (3) der Frontplatte (2) angeordnet ist; und
(c) die mindestens eine elektrisch leitfähige Schicht (6,10) mit der Auswerteelektronik (4) über mindestens einen Federkontakt (7,7',7",7'") verbunden ist,
wobei die Sensorplatte (5) dünner als die Frontplatte (2) ist, die Frontplatte (2) eine Dicke von 1 bis 10 mm und die Sensorplatte (5) eine Dicke im Bereich von 0,3 bis 3 mm hat, und zwischen Frontplatte (2) und Sensorplatte (5) mindestens ein Abstandshalter (8,8') angeordnet ist.

2. Sensorvorrichtung (1) nach Anspruch 1, **dadurch gekennzeichnet, dass** der Abstand zwischen Frontplatte (2) und Sensorplatte (5) ≤ 1 mm beträgt.

3. Sensorvorrichtung (1) nach Anspruch 1 oder 2, **dadurch gekennzeichnet, dass** der mindestens eine Abstandshalter (8,8') elektrisch leitfähig ist und eine elektrische Verbindung zwischen der mindestens einen elektrisch leitfähigen Schicht (6) und der Auswerteelektronik (4) bereitstellt.

4. Sensorvorrichtung (1) nach einem der Ansprüche 1 bis 3, **dadurch gekennzeichnet, dass** Abstandshalter (8,8') und Federkontakt (7,7',7",7'") in einem Bauteil integriert sind.

5. Sensorvorrichtung (1) nach einem der Ansprüche 1 bis 4, **dadurch gekennzeichnet, dass** sich in einem durch die Abstandshalter (8,17) zwischen Frontplatte (2) und Sensorplatte (5) definierten Zwischenraum (9) ein Füllmaterial (24) befindet.

6. Sensorvorrichtung (1) nach einem der Ansprüche 1 bis 5, **dadurch gekennzeichnet, dass** die erste Oberfläche (3) der Frontplatte (2) mindestens teilweise mit einer oder mehreren Keramikfarben (12) und/oder Leiterbahnstrukturen (11) beschichtet ist.

7. Sensorvorrichtung (1) nach Anspruch 6, **dadurch gekennzeichnet, dass** die beschichtete erste Oberfläche (3) der Frontplatte (2) erhältlich ist durch gleichzeitiges Einbrennen der Keramikfarben (12) und/oder Leiterbahnstrukturen (11).

8. Sensorvorrichtung (1) nach einem der Ansprüche 1 bis 7, **dadurch gekennzeichnet, dass** eine erste elektrisch leitfähige Schicht (6) auf einer der Frontplatte (2) zugewandten ersten Oberfläche (13) der Sensorplatte (5) angeordnet ist.

9. Sensorvorrichtung (1) nach Anspruch 8, **dadurch gekennzeichnet, dass** eine zweite elektrisch leitfähige Schicht (10) auf einer der Frontplatte (2) abgewandten zweiten Oberfläche (14) der Sensorplatte (5) angeordnet ist.

10. Sensorvorrichtung (1) nach einem der Ansprüche 1 bis 9, **dadurch gekennzeichnet, dass** der Federkontakt (7) über eine Clip-Verbindung an der Sensorplatte (5) befestigt ist.

11. Sensorvorrichtung (1) nach einem der Ansprüche 1 bis 10, **dadurch gekennzeichnet, dass** die Frontplatte (2) aus gehärtetem Einscheiben-Sicherheitsglas besteht.

12. Verfahren zur Herstellung einer kapazitiven Sensorvorrichtung (1) mit einer Frontplatte (2) aus Glas und einer Sensorplatte (5) mit mindestens einer elektrisch leitfähigen Schicht (6,10), welche bei Annäherung eines Objektes an die kapazitive Sensorvorrichtung (1) und/oder Berührung der kapazitiven Sensorvorrichtung (1) durch das Objekt ein elektrisches Signal erzeugen kann, wobei
(a) die Sensorplatte (5) aus Glas besteht und einer ersten Oberfläche (3) der Frontplatte (2) zugewandt ist;
(b) eine Auswerteelektronik (4) für die elektrischen Signale direkt auf einer unbeschichteten oder beschichteten ersten Oberfläche (3) der Frontplatte (2) angeordnet ist; und
(c) die mindestens eine elektrisch leitfähige Schicht (6,10) mit der Auswerteelektronik (4) über mindestens einen Federkontakt (7,7',7",7"') verbunden ist,
wobei die Sensorplatte (5) dünner als die Frontplatte (2) ist, die Frontplatte (2) eine Dicke von 1 bis 10 mm und die Sensorplatte (5) eine Dicke im Bereich von 0,3 bis 3 mm hat, und zwischen Frontplatte (2) und Sensorplatte (5) mindestens ein Abstandshalter (8,8') angeordnet ist;
**dadurch gekennzeichnet, dass** es die folgenden Schritte umfasst:
(i) Beschichten mindestens eines Teils der ersten Oberfläche (3) der Frontplatte (2) mit mindestens einer Keramikfarbe und/oder Leitstrukturen;
(ii1) Aufbringen der Auswerteelektronik (4) auf der beschichteten ersten Oberfläche (3) der Frontplatte (2);
(iii) Anbringen von mindestens einem Federkontakt (7,7',7",7'") auf der ersten Oberfläche der Frontplatte (2) oder der Sensorplatte (5); und
(v) Verbinden von Frontplatte (2) und Sensorplatte (5).

13. Verfahren nach Anspruch 12, **dadurch gekennzeichnet, dass** das Verbinden von Frontplatte (2) und Sensorplatte (5) durch Verkleben geschieht.

14. Verfahren nach Anspruch 12 oder 13, **dadurch gekennzeichnet, dass** die Frontplatte im Schritt (ii1) mit mindestens einem Abstandshalter (8,17) bestückt wird.

## Claims

1. Capacitive sensor device (1) with a front plate (2) made of glass and a sensor plate (5) with at least one electrically conductive layer (6,10), which can produce an electrical signal when an object approaches the capacitive sensor device (1) and/or when the object contacts the capacitive sensor device (1),
**characterized in that**
(a) the sensor plate (5) is made of glass and faces a first surface (3) of the front plate (2);
(b) an evaluation electronics (4) for the electrical signals is located directly on the uncoated or coated first surface (3) of the front plate (2); and
(c) the at least one electrically conductive layer (6,10) is connected with the evaluation electronics (4) through at least one spring contact (7,7',7",7"'),
whereby the sensor plate (5) is thinner than the front plate (2), the front plate (2) has a thickness of from 1 to 10 mm and the sensor plate (5) has a thickness of from 0,3 to 3 mm, and at least one spacer (8,8') is located between front plate (2) and sensor plate (5).

2. Sensor device (1) according to claim 1, **characterized in that** the distance between front plate (2) and sensor plate (5) is ≤ 1 mm.

3. Sensor device (1) according to claim 1 or 2, **characterized in that** the at least one spacer (8,8') is electrically conductive and provides an electric connection between the at least one electrically conductive layer (6) and the evaluation electronics (4).

4. Sensor device (1) according to one of claims 1 to 3, **characterized in that** the spacer (8,8') and the spring contact (7,7',7",7"') are integrated in one construction part.

5. Sensor device (1) according to one of claims 1 to 4, **characterized in that** a filling material (24) is located in the interspace (9) that is defined by the spacers (8,17) between front plate (2) and sensor plate (5).

6. Sensor device (1) according to one of claims 1 to 5, **characterized in that** the first surface (3) of the front plate (2) is coated at least partially with one or more ceramic paints (12) and/or conductive path structures (11).

7. Sensor device (1) according to claim 6, **characterized in that** the coated first surface (3) of the front plate (2) is obtainable by simultaneous baking of the ceramic paints (12) and/or the conductive path structures (11).

8. Sensor device (1) according to any of claims 1 to 7, **characterized in that** a first electrically conductive layer (6) is located on a first surface (13) of the sensor plate (5) which faces the front plate (2).

9. Sensor device (1) according to claim 8, **characterized in that** a second electrically conductive layer (10) is located on a second surface (14) of the sensor plate (5) which is the far side in relation to the front plate (2).

10. Sensor device (1) according to one of claims 1 to 9, **characterized in that** the spring contact (7) is attached to the sensor plate (5) via a clip connection.

11. Sensor device (1) according to one of claims 1 to 10, **characterized in that** the front plate (2) consists of hardened tempered safety glass.

12. Process for the manufacture of a capacitive sensor device (1) with a front plate (2) made of glass and a sensor plate (5) with at least one electrically conductive layer (6,10), which can produce an electrical signal when an object approaches the capacitive sensor device (1) and/or the object contacts the capacitive sensor device (1), whereby
(a) the sensor plate (5) is made of glass and faces a first surface (3) of the front plate (2);
(b) an evaluation electronics (4) for the electrical signals is located directly on the uncoated or coated first surface (3) of the front plate (2); and
(c) the at least one electrically conductive layer (6,10) is connected with the evaluation electronics (4) through at least one spring contact (7,7',7",7"'),
whereby the sensor plate (5) is thinner than the front plate (2), the front plate (2) has a thickness of from 1 to 10 mm and the sensor plate (5) has a thickness of from 0,3 to 3 mm, and at least one spacer (8,8') is located between front plate (2) and sensor plate (5);
**characterized in that** it comprises the following steps:
(i) coating of at least a part of the first surface (3) of front plate (2) with at least one ceramic paint and/or conducting structures;
(ii1) applying the evaluation electronics (4) on the coated first surface (3) of the front plate (2);
(iii) attaching at least one spring contact (7,7',7",7"') on the first surface of the front plate (2) or the sensor plate (5); and
(v) connecting the front plate (2) and the sensor plate (5).

13. Process according to claim 12, **characterized in that** the connecting of the front plate (2) and the sensor plate (5) is effected through conglutination.

14. Process according to claim 12 or 13, **characterized in that** the front plate (2) is equipped in step (ii1) with at least one spacer (8,17).

## Revendications

1. Dispositif capteur capacitif (1) avec un panneau frontal en verre (2) et une plaque de détection (5) avec au moins une couche électriquement conductrice (6, 10), qui peut produire un signal électrique dès qu'un objet s'approche et/ou entre en contact avec le dispositif capteur capacitif (1),
**caractérisé en ce que**,
(a) la plaque de détection (5) est en verre et fait face à une première surface (3) du panneau frontal (2) ;
(b) un système électronique d'évaluation (4) pour les signaux électriques est disposé directement sur la première surface (3) munie d'un revêtement ou non du panneau frontal (2) ; et
(c) au moins une couche électriquement conductrice (6, 10) est reliée avec le système électronique d'évaluation (4) par au moins un contact à ressort (7,7',7",7"'),
la plaque de détection (5) étant plus mince que le panneau frontal (2), le panneau frontal (2) ayant une épaisseur de 1 à 10 mm et la plaque de détection (5) ayant une épaisseur de 0,3 à 3 mm, et au moins un écarteur (8,8') étant disposé entre panneau frontal (2) et plaque de détection (5).

2. Dispositif capteur (1) selon la revendication 1, **caractérisé en ce que** la distance entre panneau frontal (2) et plaque de détection (5) est inférieure ou égale à 1 mm.

3. Dispositif capteur (1) selon la revendication 1 ou 2, **caractérisé en ce qu'**au moins un écarteur (8,8') est électriquement conducteur et qu'une liaison électrique est fournie entre au moins une couche électriquement conductrice (6) et le système électronique d'évaluation (4).

4. Dispositif capteur (1) selon l'une des revendications 1 à 3, **caractérisé en ce que** l'écarteur (8,8') et le contact à ressort (7,7',7",7"') sont intégrés dans un composant.

5. Dispositif capteur (1) selon l'une des revendications 1 à 4, **caractérisé en ce qu'**un matériau de remplissage (24) se trouve dans un espace (9) défini par l'écarteur (8,17) entre panneau frontal (2) et plaque de détection (5).

6. Dispositif capteur (1) selon l'une des revendications 1 à 5, **caractérisé en ce que** la première surface (3) du panneau frontal (2) est revêtue au moins partiellement d'une ou de plusieurs couleurs céramiques (12) et/ou de structures de circuits imprimés (11).

7. Dispositif capteur (1) selon la revendication 6, **caractérisé en ce que** la première surface revêtue (3) du panneau frontal (2) est obtenue par la cuisson simultanée des couleurs céramiques (12) et/ou des structures de circuits imprimés (11).

8. Dispositif capteur (1) selon l'une des revendications 1 à 7, **caractérisé en ce qu'**une première couche électriquement conductrice (6) est placée sur une première surface (13) de la plaque de détection (5) faisant face au panneau frontal (2).

9. Dispositif capteur (1) selon la revendication 8, **caractérisé en ce qu'**une deuxième couche électriquement conductrice (10) est placée sur une deuxième surface (14) de la plaque de détection (5) opposée au panneau frontal (2).

10. Dispositif capteur (1) selon l'une des revendications 1 à 9, **caractérisé en ce que** le contact à ressort (7) est fixé à la plaque de détection (5) par un clip de raccordement.

11. Dispositif capteur (1) selon l'une des revendications 1 à 10, **caractérisé en ce que** le panneau frontal (2) est constitué de verre de sécurité trempé.

12. Procédé pour la fabrication d' un dispositif capteur capacitif (1) avec un panneau frontal en verre (2) et une plaque de détection (5) avec au moins une couche électriquement conductrice (6,10), qui peut produire un signal électrique dès qu'un objet s'approche et/ou entre en contact avec le dispositif capteur capacitif (1), **caractérisé en ce que**,
(a) la plaque de détection (5) est en verre et fait face à une première surface (3) du panneau frontal (2) ;
(b) un système électronique d'évaluation (4) pour les signaux électriques est disposé sur la première surface (3) munie d'un revêtement ou non du panneau frontal (2) ; et
(c) au moins une couche électriquement conductrice (6, 10) est reliée avec le système électronique d'évaluation (4) par au moins un contact à ressort (7,7',7",7"'),
la plaque de détection (5) étant plus mince que le panneau frontal (2), le panneau frontal (2) ayant une épaisseur de 1 à 10 mm et la plaque de détection (5) ayant une épaisseur de 0,3 à 3 mm, et au moins un écarteur (8,8') étant disposé entre panneau frontal (2) et plaque de détection (5) ;
**caractérisé en ce qu'**il comporte les étapes suivantes :
(i) Revêtement d'au moins un partie de la première surface (3) du panneau frontal (2) avec au moins une couleur céramique et/ou des structures conductrices ;
(ii1) Mise en place du système électronique d'évaluation (4) sur la première surface revêtue (3) du panneau frontal (2) ;
(iii) Mise en place d'au moins un contact à ressort (7,7',7",7"') sur la première surface du panneau frontal (2) ou de la plaque de détection (5) ; et
(v) Connexion du panneau frontal (2) et de la plaque de détection (5).

13. Procédé selon la revendication 12, **caractérisé en ce que** la connexion du panneau frontal (2) et de la plaque de détection (5) se fait par collage.

14. Procédé selon la revendication 12 ou 13, **caractérisé en ce que** le panneau frontal (2) dans l'étape (ii1) sera muni d'au moins un écarteur (8,17).
